Europäisches Patentamt

European Patent Office

Office européen des brevets

(19)

(11) **EP 1 484 616 A1**

(12) **DEMANDE DE BREVET EUROPEEN**

(43) Date de publication:
**08.12.2004 Bulletin 2004/50**

(51) Int Cl.⁷: **G01R 31/12**

(21) Numéro de dépôt: **04102489.4**

(22) Date de dépôt: **03.06.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **05.06.2003 FR 0306808**

(71) Demandeur: **Areva T&D SA
92309 Levallois-Perret Cedex (FR)**

(72) Inventeur: **Kuppuswamy, Raja
75018 Paris (FR)**

(74) Mandataire: **Poulin, Gérard
Brevatome
3, rue du Docteur Lancereaux
75008 Paris (FR)**

(54) **Méthode de détection de décharges partielles et système de diagnostic pour appareil électrique**

(57) L'invention fournit une méthode pour détecter des décharges partielles dans un appareil électrique isolé dans une cuve et un système de diagnostic de l'état de l'appareil utilisant cette méthode. A l'aide d'une antenne UHF placée dans la cuve de l'appareil, la méthode consiste à analyser le spectre (RS1) du signal électromagnétique capté par l'antenne et à identifier dans le spectre une ou plusieurs fréquences d'intérêt (B1,B2) pour chacune desquelles le signal a une amplitude supérieure à une valeur de seuil prédéterminée. Pour identifier la ou les fréquences d'intérêt, on compare le spectre du signal reçu sur l'antenne avec un spectre de référence (RS2).

Fig-3

## Description

L'invention concerne la détection des décharges électriques partielles survenant dans les appareils électriques haute tension isolés dans une cuve, comme un transformateur isolé dans un diélectrique liquide. La détection des décharges électriques partielles permet de diagnostiquer les défauts d'isolation de l'appareil électrique et d'évaluer la durée de vie de ce dernier.

Classiquement, pour détecter la présence de décharges électriques partielles dans la cuve d'un tel appareil électrique, on s'appuie sur la mesure du rayonnement électromagnétique à l'intérieur de la cuve à l'aide d'une antenne UHF. Cette méthode permet de procéder au diagnostic de l'appareil électrique sans avoir à interrompre son exploitation.

Cependant, le rayonnement électromagnétique capté par l'antenne UHF comprend une quantité importante de bruit électromagnétique qui perturbe la fiabilité des mesures. Ce bruit qui est entre autres dû à des décharges corona ayant lieu dans l'environnement de l'appareil électrique est complexe à prendre en compte du fait qu'il dépend de l'environnement de l'appareil électrique testé, de sa charge ainsi que d'autres paramètres. Le bruit électromagnétique est notamment très différent d'un appareil à l'autre ce qui rend la mise en évidence de décharges partielles difficile à réaliser.

Le document de brevet US-2002163344 enseigne de réaliser une analyse spectrale du signal électromagnétique capté par l'antenne UHF consistant à comparer l'amplitude maximale du signal à des valeurs de seuil pour une ou plusieurs fréquences prédéterminées. Cette méthode pour détecter des décharges partielles dans la cuve d'un appareil électrique tend à s'affranchir du bruit présent dans le signal reçu par l'antenne. Cependant, ce bruit étant très différent d'un appareil à un autre, la précision de la détection reste insuffisante. Dans ce document, il est suggéré de réaliser la comparaison avec un réseau de neurones. La diversité des bruits électromagnétiques étant importante, le recours à un réseau de neurones ne semble pas de nature à obtenir une amélioration de la fiabilité de la détection.

Le brevet WO-0118554 décrit un appareil incluant un capteur d'ultrasons et une plaque capacitive plate pour détecter respectivement, une impulsion ultrasonore et une impulsion radiofréquence générées par une décharge partielle. Les signaux des capteurs sont analysés par traitement du signal pour déterminer l'apparition de décharges. Lorsqu'une décharge apparaît dans l'appareil, elle produit une onde de pression ultrasonore qui se déplace selon les lois physiques classiques et qui est perçue par le capteur 2 d'ultrasons. Si une impulsion radiofréquence a été détectée dans un intervalle de temps prédéterminé avant le signal ultrasonore, on considère qu'une décharge partielle est réellement apparue. Cette combinaison d'ondes ultrasonores et radiofréquences n'est cependant pas indépendante du bruit. Plusieurs sources de bruit peuvent perturber les mesures, la plus importante étant issue de la magnétostriction du noyau du transformateur qui génère continûment des ultrasons.

Dans une autre méthode de mesure connue, un circuit résonant RLC est connecté à une partie isolante de l'appareil électrique, et un condensateur est monté en série avec le circuit résonnant pour former une boucle de décharge. Une impédance isole généralement la boucle de décharge de la source haute tension. Le circuit RLC a une plage de résonance située entre 30kHz et 300kHz et est configuré pour délivrer un signal de réponse ayant une fréquence prédéfinie, qui peut être facilement détectée par un appareil de mesure. Cette méthode est adaptée à des tests sous faible bruit électromagnétique comme par exemple en laboratoire. En effet, le circuit résonnant fournit la même réponse pour tous les signaux d'impulsion, si bien qu'il n'est pas possible de distinguer le signal de décharge partielle du bruit.

Dans une autre méthode connue, chaque signal de décharge partielle est enregistré avec un appareil à large bande passante tel qu'un transformateur de courant pour radio fréquence. Les résultats de ce type de mesure sont des enregistrements à une échelle de temps inférieure à la microseconde, ce qui correspond à une bande de fréquences allant jusqu'à quelques MHz.

La bande de fréquences de travail de quelques MHz ne permet pas d'exclure le bruit dû aux décharges corona dont la bande de fréquence s'étend bien au delà (jusqu'à environ 200MHz).

Le brevet US-6313640 décrit une méthode consistant à utiliser deux capteurs pour déterminer si les signaux de décharge partielle proviennent de l'intérieur de la cuve de l'appareil ou d'une source externe. Un premier capteur est relié à la ligne de transport de courant en entrée du transformateur. Un second capteur est placé en sortie du transformateur. Les signaux issus des deux capteurs sont injectés dans une unité de comparaison qui calcule la différence de ces deux signaux de telle sorte que le signal résultant est représentatif des décharges partielles ayant lieu dans l'appareil. Cette méthode nécessite de mettre l'appareil hors ligne pour calibrer l'unité de comparaison avant de procéder au diagnostic, en injectant dans l'appareil des signaux étalon et en ajustant les gains de l'unité de comparaison pour obtenir un signal résultant nul. D'autre part, les capteurs utilisés sont sensibles dans une bande de fréquence s'étendant jusqu'à 10 MHz, ce qui inclut les fréquences correspondant à des décharges corona de forte amplitude.

Dans une autre méthode, connue du document de brevet US-6323655, des antennes sont installées dans la cuve de l'appareil pour détecter des signaux de décharge partielle dans la gamme des fréquences UHF. Le système de mesure est sensible dans l'une des deux bandes 300 - 600MHz ou 600MHz - 1,2GHz, ce qui correspond à des bandes de fréquence non perturbées par les décharges corona. Cependant ces deux bandes de fréquence comprennent respectivement les signaux d'émission de télévision ainsi que les signaux correspondant aux réseaux de téléphones mobiles. Par conséquent, ces bandes de fréquence plus élevées permettent de s'affranchir des décharges corona, mais comprennent d'autres sources de bruit électromagnétique qui perturbent significativement les mesures.

Le but de l'invention est de proposer une méthode améliorée pour détecter des décharges partielles.

A cet effet, l'invention concerne une méthode pour détecter des décharges partielles dans un appareil électrique isolé dans une cuve, à l'aide d'une antenne UHF placée dans cette cuve, consistant à analyser le spectre du signal électromagnétique capté par l'antenne et à identifier dans le spectre une ou plusieurs fréquences d'intérêt pour chacune desquelles le signal a une amplitude supérieure à une valeur de seuil prédéterminée, caractérisé en ce que pour identifier la ou les fréquences d'intérêt, on compare le spectre du signal reçu sur l'antenne avec un spectre de référence.

Une méthode selon l'invention peut présenter en outre les particularités suivantes :

- on identifie une fréquence d'intérêt quand la différence d'amplitude pour cette fréquence d'intérêt entre le spectre du signal reçu sur l'antenne et le spectre de référence est supérieure à une valeur de seuil prédéterminée.
- on identifie une fréquence d'intérêt quand le rapport d'amplitude pour cette fréquence entre le spectre du signal reçu sur l'antenne et le spectre de référence est supérieur à une valeur de seuil prédéterminée.

L'invention a également pour objet une méthode pour détecter des décharges partielles dans un appareil électrique isolé dans une cuve, à l'aide d'une antenne UHF placée dans cette cuve, consistant à analyser le spectre du signal électromagnétique capté par l'antenne et à identifier dans le spectre plusieurs fréquences d'intérêt pour chacune desquelles le signal a une amplitude supérieure à une valeur de seuil prédéterminée, caractérisé en ce que, pour identifier les fréquences d'intérêt, on compare le spectre du signal reçu sur l'antenne avec un spectre de référence comme suit :

- on calcule, pour plusieurs intervalles de fréquences prédéfinis dans les deux spectres, une valeur caractéristique de l'intervalle de chaque spectre, et
- on compare, intervalle par intervalle, les valeurs caractéristiques des deux spectres.

La valeur caractéristique de l'intervalle de chaque spectre est, par exemple, une valeur moyenne de l'amplitude du signal dans l'intervalle ou l'énergie du signal dans l'intervalle.

Selon un premier mode de réalisation de l'invention, le spectre de référence est représentatif d'un signal électromagnétique capté par l'antenne lorsque l'appareil électrique est hors service ou à la première mise en service de l'appareil électrique.

Selon un deuxième mode de réalisation de l'invention, le spectre de référence est représentatif d'un signal électromagnétique capté par une seconde antenne UHF placée dans une enceinte métallique à proximité de l'appareil électrique.

L'invention s'étend à un système pour diagnostiquer l'état d'isolation d'un ou plusieurs appareils électriques isolés chacun dans une cuve, comprenant une unité de traitement de données et de commande agencée pour mettre en oeuvre la méthode ci-dessus de détection de décharges partielles et comprenant une pluralité d'antennes UHF fournissant une pluralité de signaux électromagnétiques, les dites antennes étant reliées à l'unité de traitement et de commande par l'intermédiaire d'un convertisseur parallèle série incluant un multiplexeur électromagnétique haute fréquence qui transforme les flux parallèles de signaux électromagnétiques en un flux unique d'un signal électromagnétique.

L'invention sera maintenant décrite plus en détail en référence aux dessins annexés qui en illustrent une forme de réalisation à titre d'exemple non limitatif.

La figure 1 est une illustration schématique de la conversion du signal reçu par l'antenne en une représentation spectrale ;

La figure 2 est une représentation schématique d'un convertisseur connecté à l'antenne ;

La figure 3 donne les spectres représentatifs d'un signal de décharge partielle et d'un signal de bruit électromagnétique ;

La figure 4 est une illustration du procédé d'identification selon l'invention ;

La figure 5 est un schéma bloc représentant une première mise en oeuvre du procédé selon l'invention ;

La figure 6 est un schéma bloc représentant une seconde mise en oeuvre du procédé selon l'invention ;

La figure 7 est un schéma bloc représentant une troisième mise en oeuvre du procédé selon l'invention ;

La figure 8 est un schéma bloc représentant une quatrième mise en oeuvre du procédé selon l'invention ;

La figure 9 illustre de façon schématique la structure d'un convertisseur parallèle série comprenant un multiplexeur électromagnétique utilisé pour le traitement des signaux en sortie des antennes ;

La figure 10 illustre de façon schématique les signaux de puissance envoyé sur le multiplexeur électromagnétique ;

La figure 11 illustre un algorithme pour identifier les fréquences d'intérêt avec la méthode selon l'invention.

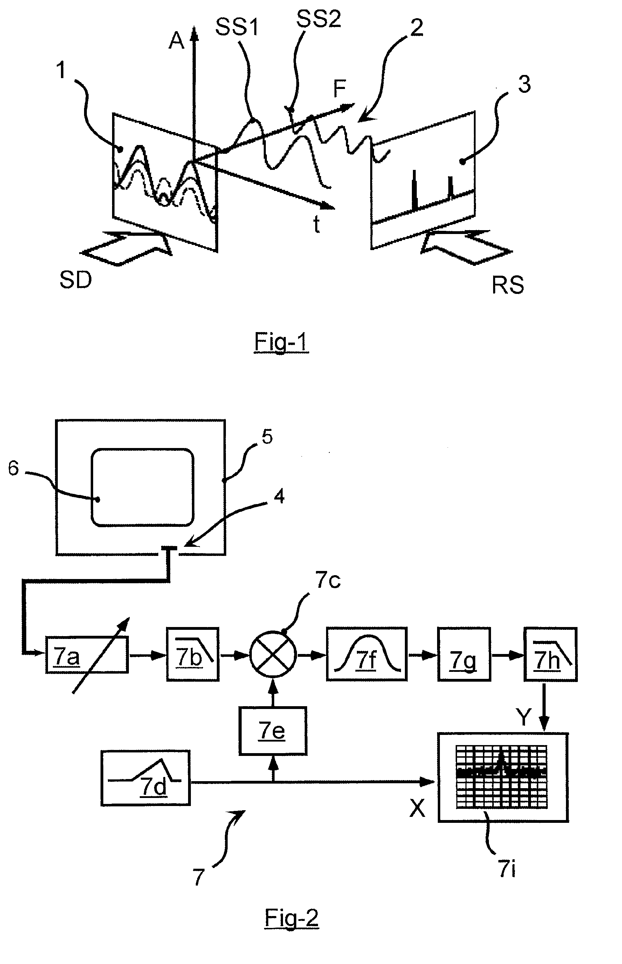

Figure 1, un signal de décharge partielle SD est montré dans sa représentation temporelle 1 donnant son amplitude A en fonction du temps t. Ce signal SD est décomposé en 2 en ses différentes composantes sinusoïdales telles que SS1, SS2 pour être converti sous la forme d'un spectre de fréquences selon la représentation 3. Comme connu, cette représentation spectrale donne l'amplitude de chaque composante sinusoïdale du signal SD en fonction de sa fréquence F.

Dans l'invention, cette conversion d'un signal temporel SD en une représentation spectrale RS sera par exemple réalisée avec un convertisseur de signal, tel que celui qui est représenté sur la figure 2.

Figure 2, un convertisseur de signal reçoit en entrée le signal d'une antenne UHF 4 pour délivrer en sortie le spectre de ce signal d'entrée. L'antenne 4 est placée à l'intérieur de la cuve étanche 5 d'un appareil électrique qui est ici un transformateur comprenant un bobinage 6 noyé dans un liquide diélectrique comme de l'huile. L'appareil électrique 6 pourrait être aussi un disjoncteur noyé dans un gaz diélectrique à l'intérieur d'une cuve étanche. Le convertisseur de signal 7 est représenté par un schéma bloc dans lequel le signal d'entrée reçu sur l'antenne 4 est atténué par une résistance réglable 7a puis filtré dans un filtre passe-bas 7b pour en éliminer les harmoniques de rang élevé, avant d'être injecté dans un mélangeur 7c. L'autre entrée de ce mélangeur 7c reçoit le signal d'un oscillateur 7e qui est excité par un générateur de rampe 7d, pour générer un signal balayant progressivement les fréquences d'intérêt dans le sens croissant. Le signal obtenu en sortie du mélangeur 7c est ainsi représentatif des amplitudes des fréquences d'intérêt du signal reçu sur l'antenne 4. Le signal fourni par le mélangeur 7c est filtré et amplifié dans les blocs 7f, 7g, 7h pour piloter l'entrée Y d'un oscilloscope 7i, l'entrée X de cet oscilloscope étant pilotée par la rampe d'impulsion 7e de manière à former le spectre du signal d'entrée qui est représenté dans le bloc 7i. Un tel convertisseur pourra avantageusement être utilisé pour la mise en oeuvre de la méthode selon l'invention, ce qui sera détaillé plus bas.

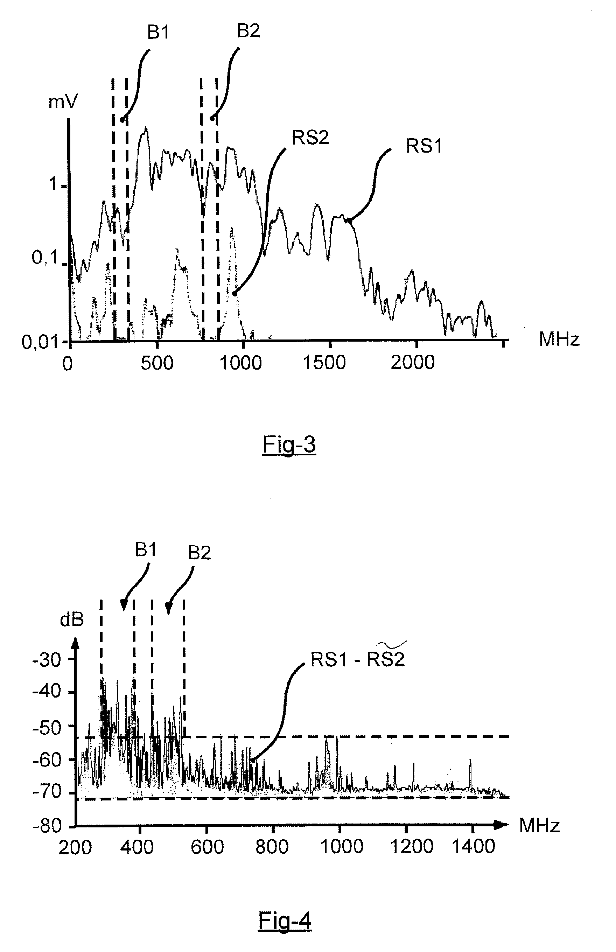

Figure 3, un graphique fait apparaître deux spectres RS1 et RS2 représentatifs respectivement d'une décharge partielle perçue dans la cuve d'un appareil électrique et du bruit électromagnétique dans lequel baigne cet appareil électrique à diagnostiquer. Plus particulièrement, le premier spectre RS1 est représentatif du signal recueilli sur l'antenne 4 durant une décharge partielle. Le second spectre RS2 est un spectre de référence qui est par exemple représentatif d'un signal recueilli sur l'antenne 4 lorsque l'appareil électrique ne génère pas de décharge partielle, par exemple lorsque l'appareil électrique est hors service. Ainsi, le premier spectre RS1 représente des signaux de décharge partielle additionnés à des signaux de bruit électromagnétique, alors que le second spectre RS2 est représentatif seulement de signaux de bruit électromagnétique. Cette figure 3 fait apparaître que le bruit électromagnétique RS2 a une amplitude qui varie énormément en fonction de la fréquence. En particulier, le bruit électromagnétique est quasiment nul dans deux bandes de fréquences notées B1 et B2, et situées respectivement entre 300 et 350MHz et entre 800 et 850Hz. Le bruit électromagnétique est également nul pour les fréquences situées au-delà de 1GHz.

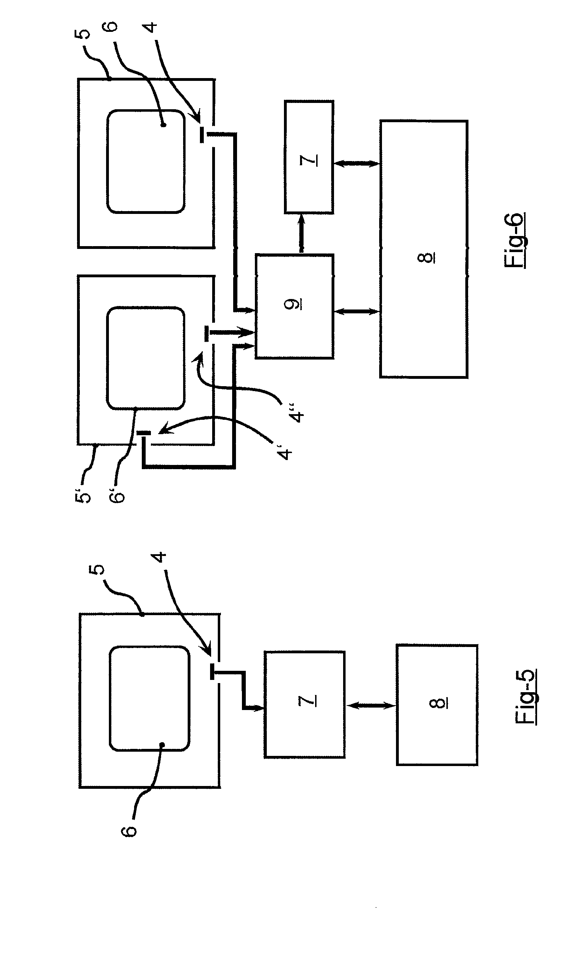

Selon l'invention, le spectre RS1 du signal reçu sur l'antenne 4 est comparé au spectre de référence RS2 de manière à identifier une ou plusieurs fréquences d'intérêt pour lesquelles le signal et le bruit satisfont à un critère de choix. Le critère pour identifier les fréquences d'intérêt peut par exemple consister à retenir les fréquences pour lesquelles le rapport des amplitudes de RS1 sur RS2 est supérieur à une valeur prédéterminée, ce qui correspond au rapport signal/bruit. Ce critère peut aussi de préférence consister à calculer pour une fréquence, la différence d'amplitude entre le spectre RS1 et le spectre RS2 de manière à identifier cette fréquence comme fréquence d'intérêt si cette différence est supérieure à une valeur seuil prédéterminée, ce qui est illustré dans la figure 4.

L'identification des fréquences d'intérêt peut également consister à identifier des bandes de fréquences d'intérêt. Sur la figure 4, la différence des spectres est toujours supérieure à -70dB, ce qui correspond à un contexte dans lequel le bruit est très faible et pour lequel toutes les fréquences pourraient être identifiées comme des fréquences d'intérêt. Le choix d'une valeur de seuil de -55dB conduit à identifier les bandes de fréquences BI et B2 comme bandes de fréquences d'intérêt, B1 et B2. correspondant respectivement aux fréquences comprises entre 300 et 400MHz, et entre 450 et 550MHz.

Le spectre de référence RS2 peut être représentatif du signal reçu sur l'antenne 4 lorsque l'appareil électrique ne génère pas de décharge partielle, ce spectre étant issu de mesures de référence réalisées par exemple durant la première mise en service de l'appareil ou lors de sa mise hors service. La fiabilité de la méthode est ainsi indépendante des caractéristiques particulières de l'appareil et de son environnement puisque celles-ci sont prises en compte durant les mesures de référence.

Ce spectre de référence RS2 peut aussi être issu d'un signal capté par une seconde antenne située dans une enceinte métallique placée à proximité de l'appareil électrique à diagnostiquer. Cette seconde antenne est en particulier placée dans une enceinte métallique située à proximité de l'appareil électrique à diagnostiquer de sorte que le signal capté par la seconde antenne est représentatif seulement du bruit électromagnétique régnant dans l'environnement de l'appareil électrique à diagnostiquer. En effet, les éventuelles décharges partielles ayant lieu dans la cuve de l'appareil électrique à diagnostiquer, le rayonnement électromagnétique qu'elles génèrent est confiné dans la cuve de l'appareil électrique, de sorte que ces décharges ne sont pas perçues par la seconde antenne. De manière analogue, la fiabilité de la méthode est indépendante des caractéristiques de l'environnement de l'appareil électrique à diagnostiquer puisque celles-ci sont prises en compte par le signal de référence qui est reçu sur la seconde antenne.

Comme représenté schématiquement figure 5, la méthode selon l'invention peut être mise en oeuvre en connectant l'antenne 4 par l'intermédiaire d'un câble coaxial à l'entrée d'un convertisseur de signal 7 qui est lui-même connecté à une unité de traitement de données et de commande 8. Le convertisseur 7 est piloté par l'unité 8 pour fournir une représentation spectrale du signal reçu sur l'antenne 4 dans une ou plusieurs bandes de fréquence qui lui sont communiquées par l'unité 8. L'unité 8 est par exemple ici un ordinateur portable.

Durant l'étape d'identification, le convertisseur 7 est piloté par l'unité 8 pour fournir un spectre RS1 du signal reçu sur l'antenne 4 dans toute la gamme des fréquences comprises par exemple entre 200MHz et 1,5GHz. Ce spectre RS1 est enregistré dans l'unité 8 pour identifier une ou plusieurs bandes de fréquences d'intérêt en le comparant avec un spectre de référence RS2 préenregistré dans cette unité 8. Le convertisseur 7 est ensuite piloté par l'unité 8 pour fournir un spectre du signal reçu sur l'antenne 4 uniquement aux fréquences d'intérêt, ce spectre étant enregistré dans l'unité 8 pour la détection de déchargés partielles. La détection de décharges partielles consiste ensuite à détecter des pics ayant une amplitude supérieure à une valeur de seuil prédéterminée, dans le spectre issu du convertisseur.

Avantageusement, la comparaison du spectre RS1 du signal reçu sur l'antenne 4 avec le spectre de référence RS2 inclut une étape de discrétisation. Cette discrétisation consiste à découper la gamme des fréquences en plusieurs intervalles de fréquences réguliers, et à calculer la valeur moyenne du spectre pour chaque intervalle. Cette discrétisation est appliquée séparément au spectre représentatif du signal reçu sur l'antenne 4 et au spectre de référence. L'identification de bandes de fréquences d'intérêt consiste ensuite à comparer pour chaque intervalle de fréquence la valeur moyenne pour le spectre issu de l'antenne avec la valeur moyenne issue du spectre de référence pour vérifier si cette bande de fréquence satisfait ou non au critère de comparaison choisi. Le temps de traitement peut être réduit en augmentant la taille des intervalles, et, réciproquement, la précision peut être augmentée en réduisant la taille de ces intervalles. Cette comparaison peut avantageusement consister à comparer pour chaque intervalle de fréquence l'énergie du signal pour chaque spectre. En effet, pour un intervalle donné, l'énergie du signal dans cet intervalle constitue une grandeur plus significative que la valeur moyenne de l'amplitude du signal dans cet intervalle.

Dans un mode de réalisation représenté figure 6, une unité de traitement de données et de commande 8 est reliée à plusieurs antennes 4, 4', 4" de manière à diagnostiquer la présence de décharges partielles simultanément dans plusieurs appareils électriques. Dans cet exemple, deux appareils électriques 5, 6, et 5', 6' sont chacun équipés d'antennes UHF, ces antennes étant reliées par des câbles coaxiaux à un convertisseur de signal 7 à travers un convertisseur parallèle série 9. Le convertisseur parallèle série 9 est piloté par l'unité 8 de manière à sélectionner l'une des trois antennes pour soumettre le signal qu'elle reçoit au convertisseur 7 comme décrit plus loin. Il est ainsi possible de procéder à l'identification des fréquences d'intérêt séparément pour chaque antenne dans l'unité 8. Après cette identification, l'unité 8 peut piloter parallèlement le convertisseur parallèle série 9 et le convertisseur de signal 7 pour sélectionner tout à tour chaque antenne, de manière à procéder cycliquement au suivi de chaque antenne dans l'unité 8.

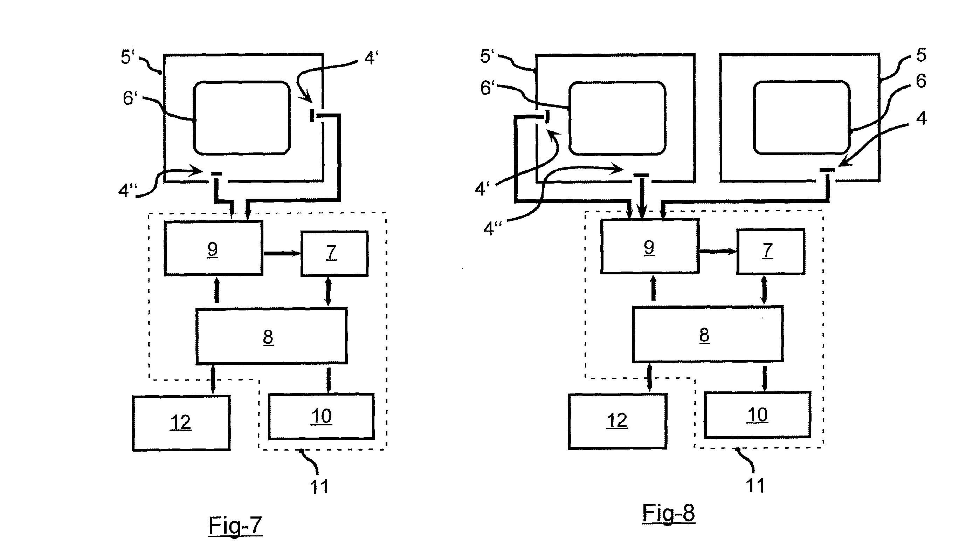

Dans un autre mode de réalisation représenté figure 7, la méthode est implémentée pour réaliser un suivi permanent d'un appareillage électrique à partir d'une unité spécialisée qui est installée à demeure. Ici, l'unité 8 est connectée à un dispositif d'alarme 10 tel qu'une alarme sonore qui est activée lorsque l'évolution des détections des décharges partielles dépasse un certain seuil. Plus particulièrement, le convertisseur parallèle-série 9, le convertisseur de signal 7, l'unité 8 et l'alarme 10 sont regroupés dans une unité spécialisée 11 qui est installée à demeure ou pour une durée prédéterminée sur site, par exemple à proximité de l'appareil électrique à diagnostiquer. L'unité 8 peut être réduite à un microprocesseur programmé pour piloter le convertisseur parallèle-série 9 et le convertisseur de signal 7 avec possibilité de communiquer avec des moyens externes comme un ordinateur 12 à travers une liaison réseau pour échanger des données avec celui-ci. Plusieurs unités spécialisées 11 peuvent être pilotées par cet ordinateur central avec lequel un opérateur peut obtenir de manière centralisée les données issues de chaque unité spécialisée 11, et paramétrer à distance le fonctionnement de chaque unité spécialisée 11.

Une même unité spécialisée 11 peut aussi être connectée à plusieurs appareils électriques 5 et 5' sous surveillance, comme représenté schématiquement sur la figure 8. De manière analogue, cette unité spécialisée 11 est pilotée par un ordinateur 12 qui est programmé pour fournir des paramètres de fonctionnement au convertisseur parallèle série 9 et au convertisseur de signal 7 à travers l'unité centrale 8.

Dans les figures 6 à 8, le convertisseur parallèle série 9 conditionne des flux parallèles de signaux d'entrée produits par les antennes telles que 4,4',4" en un flux unique à l'aide d'un signal d'horloge ou signal de découpage produit par l'unité 8 et définissant des fenêtres temporelles de multiplexage des signaux d'entrée, le nombre de fenêtres temporelles dans un cycle correspondant au nombre d'antennes gérées par l'unité 8.

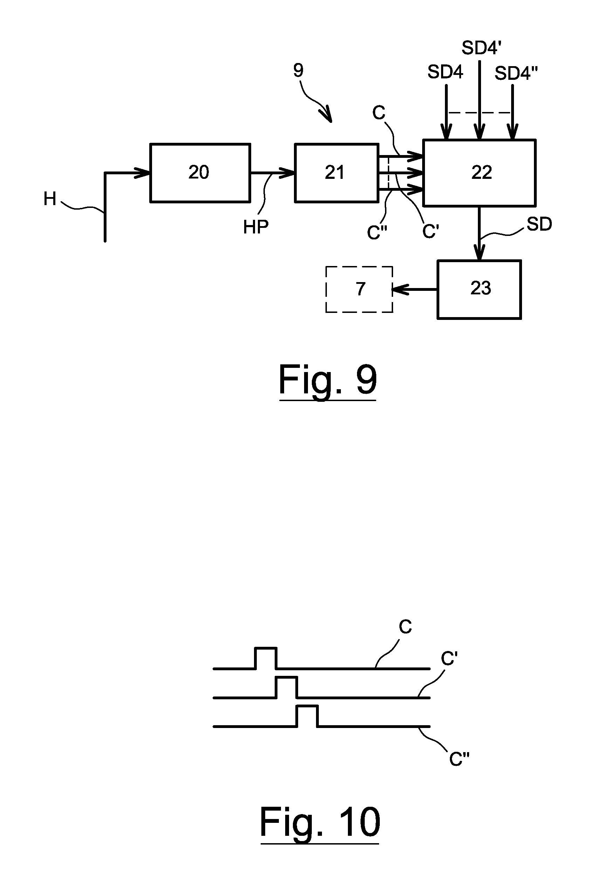

Les figures 9 et 10 illustrent un exemple de réalisation du convertisseur parallèle série 9 incluant un multiplexeur électromagnétique haute fréquence. Sur la figure 9, on a représenté par SD4,SD4',SD4" trois signaux produits par les antennes 4,4',4". Le signal H est un signal d'horloge produit par exemple par un port série RS232/RS422/RS485/USB de l'unité 8 et dont les impulsions définissent des fenêtres temporelles de multiplexage. Le signal de multiplexage H est transformé par un générateur 20 en un signal de puissance du type TTL, indiqué sur la figure 9 par la référence HP et ensuite par un convertisseur série/parallèle 21 en une série de signaux de puissance C,C',C" qui définissent ensemble des fenêtres temporelles décalées deux à deux dans le temps et illustrées sur la figure 10. Ces signaux de puissance C,C',C" servent de signaux pour la commande des relais d'un multiplexeur électromagnétique 22 recevant en entrée les signaux SD4,SD4',SD4". Comme les signaux de puissance définissent des fenêtres décalées dans le temps, les signaux d'entrée SD4,SD4',SD4" sont découpés et multiplexés dans un signal de sortie SD qui est amplifié dans un amplificateur large bande à haute fréquence 23 avant d'être envoyé dans le convertisseur de signal 7.

Comme indiqué plus haut, l'évolution des détections des décharges partielles peut être suivie dans le temps et être normalisée par expérimentation sous la forme d'une donnée représentative de l'état d'isolation de l'appareil sous surveillance ce qui permet de réaliser un diagnostic sur l'appareil sous surveillance pour une maintenance prédictive.

Plus particulièrement, la trace d'un signal après séparation du bruit est récupérée en continue et son énergie (surface située entre la trace et l'abscisse) est calculée et normalisée, la normalisation pouvant correspondre à la division de l'énergie par une valeur établie par expérimentation. La valeur résultante de la normalisation peut servir à indexer ou classer dans le temps l'évolution des détections de décharges partielles et donc l'état d'isolation de l'appareil électrique sous surveillance. Cette valeur résultante est comparée à des valeurs préétablies correspondant à des niveaux préétablis d'activation d'alarme, ces niveaux d'activation d'alarme étant indicatifs respectivement des différents états d'isolation de l'appareil sous surveillance, par exemple état normal, état anormal, état critique, .... Si un de ces niveaux d'activation est dépassé par la valeur résultante, un signal d'alarme correspondant est envoyé. L'alarme peut être sonore, visuelle ou autre pour fournir un signal approprié au personnel en charge du contrôle et de la surveillance de l'appareil électrique. Elle peut être placée à proximité ou à distance de l'appareil électrique sous surveillance.

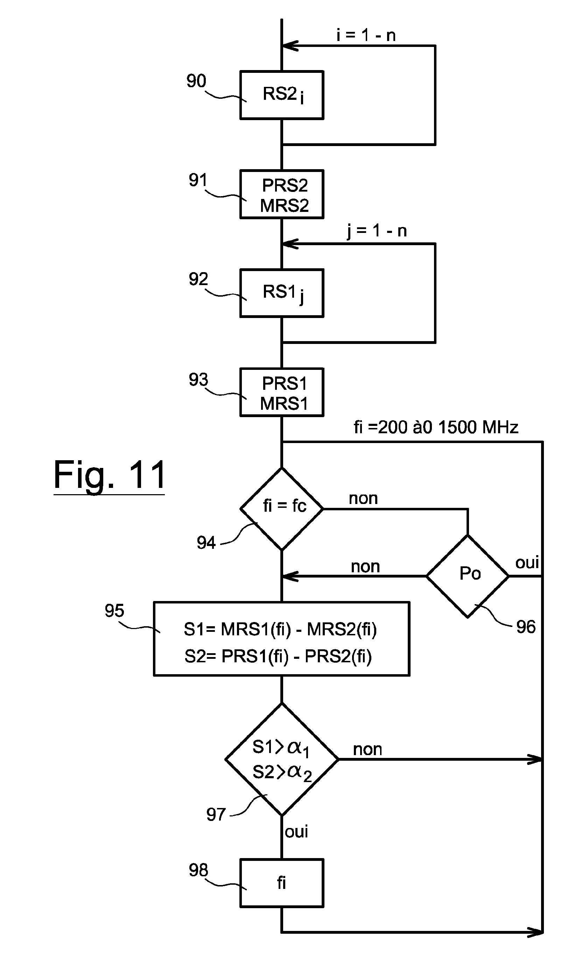

La figure 11 illustre un algorithme pour la détection des fréquences d'intérêt avec prise en compte de fréquences connues fc représentatives d'un bruit connu (fréquences des radiotéléphones, signaux vidéo de télévision, etc...). Ces fréquences connues sont stockées en mémoire dans une base de données pour la mise en oeuvre de l'algorithme.

Le bloc 90 sur la figure 11 représente une étape d'acquisition d'une série i de spectres de bruit RS2i. Chaque spectre de bruit RS2i est stockée en mémoire dans un mode d'acquisition dit « pic maximum » selon lequel l'amplitude du spectre à chaque fréquence est maintenue constant jusqu'à ce qu'une nouvelle valeur d'amplitude plus importante que la précédente soit détectée. Cet étape 90 peut être répétée de façon cyclique dans le temps. A la suite de l'étape 90, on calcule en 91, pour chaque fréquence dans la série de spectres de bruit RS2i, une valeur moyenne d'amplitude et une valeur maximale d'amplitude de sorte à obtenir un spectre de référence en valeur moyenne et en pic maximum indiqués respectivement par MRS2 et PRS2.

Le bloc 92 représente l'étape d'acquisition du spectre du signal reçu sur une antenne 4. Dans cette étape, une série j de spectres RS1j sont acquis et stockés en mémoire. Cette étape 92 peut être répétée également de façon cyclique dans le temps. A la suite de l'étape 92, on calcule en 93, pour chaque fréquence dans la série de spectres RS2j, une valeur moyenne d'amplitude et une valeur maximale d'amplitude de sorte à obtenir un spectre du signal capté par l'antenne 4 en valeur moyenne et en pic maximum indiqués respectivement par MRS1 et PRS1.

A noter que dans les étapes 90 et 92, les spectres sont construits avec le même niveau de résolution en fréquence.

A la suite de l'étape 93, on déroule un traitement itératif de détection des fréquences d'intérêt, partant par exemple d'une première fréquence à 200MHz et terminant à une fréquence de 1500MHz par exemple, avec un incrément de 1MHz par exemple.

Dans l'étape 94, on recherche d'abord si la fréquence courante fi est une fréquence connue fc et dans le cas positif on passe à l'étape 95. Dans le cas négatif, on passe à l'étape 96.

A l'étape 95, on calcule d'une part la différence d'amplitude, à la fréquence fi, entre le spectre RS1 et le spectre RS2, pour les valeurs moyennes et pour les valeurs en pic maximum. Ceci est représenté par les relations

$$S1 = MRS1 (fi) - MRS2 (fi)$$

$$S2 = PRS1 (fi) - PRS2 (fi)$$

Si l'une ou l'autre des valeurs S1 et S2 est supérieure à une valeur de seuil indiquée par $\alpha$, comme indiqué dans le bloc 97, la fréquence courante fi est retenue comme fréquence d'intérêt ce qui est représenté dans le bloc 98. Dans le cas contraire, on poursuit le traitement itératif pour une nouvelle fréquence fi en revenant à l'étape indiquée dans le bloc 94.

Maintenant à l'étape 96, c'est-à-dire après avoir détecté que la fréquence courante n'est pas une fréquence connue d'un bruit connu, on calcule pour la fréquence courante la distribution de l'amplitude du spectre RS1 et on vérifie la probabilité Po de distribution de cette amplitude dans la série de spectres RS1j.

Dans le cas où cette probabilité de distribution suit une distribution uniforme ou Gaussienne, on poursuit le traitement itératif sur une nouvelle fréquence courante en revenant à l'étape 94. Plus particulièrement, on part du constat qu'en général les bruits électromagnétiques ont une nature plus déterministe que probabiliste. Les techniques d'acquisition des signaux SD selon l'invention impliquent l'acquisition de signaux UHF dans des intervalles de temps de l'ordre de quelques secondes à quelques minutes, et même quelques heures soit en continu soit de façon échelonné dans le temps. Si le signal recueilli à une fréquence donnée, correspond à un bruit électromagnétique, il y a une possibilité qu'il n'existe pas de corrélation de tels signaux acquis à des instants différents, c'est-à-dire que ces événements sont indépendants les uns des autres. De telles situations peuvent être habituellement détectées en utilisant une distribution Gaussienne. Selon les fondements théoriques, les événements aléatoires ou indépendants sont le mieux modélisés par une distribution Gaussienne ou normale. L'autre possibilité pour caractériser des bruits électromagnétiques déterministes est une distribution rectangulaire ou uniforme. En d'autres termes, l'amplitude des événements reste constante dans le temps dans une limite tolérable de variations statistiques. Les signaux résultant de tels événements sont dépendants de la condition de l'isolation de l'appareil électrique sous surveillance.

A l'étape 94, si la probabilité de distribution ne suit pas une distribution uniforme ou Gaussienne, on poursuit le traitement successivement sur les étapes 95, 97 et 98 à la différence que dans l'étape 97, la valeur de seuil $\alpha$ est ajustée en fonction du taux de confiance de la probabilité d'identification de la distribution.

A la suite de l'étape 98, le traitement itératif se poursuit pour une nouvelle fréquence courante à partir du bloc 94, jusqu'à ce qu'au balayage complet de l'ensemble des fréquences de la bande de fréquence 200-1500MHz.

**Revendications**

1. Méthode pour détecter des décharges partielles dans un appareil électrique (6) isolé dans une cuve (5), à l'aide d'une antenne UHF (4) placée dans cette cuve, consistant à analyser le spectre (RS1) du signal électromagnétique capté par l'antenne et à identifier dans le spectre plusieurs fréquences d'intérêt (B1, B2) pour chacune desquelles le signal a une amplitude supérieure à une valeur de seuil prédéterminée, **caractérisée en ce que**, pour identifier les fréquences d'intérêt, on compare le spectre du signal reçu sur l'antenne avec un spectre de référence (SR2) comme suit :

   - on calcule, pour plusieurs intervalles de fréquences prédéfinis dans les deux spectres (RS1, RS2), une valeur caractéristique de l'intervalle de chaque spectre, et
   - on compare, intervalle par intervalle, les valeurs caractéristiques des deux spectres (RS1, RS2).

2. Méthode selon la revendication 1, **caractérisée en ce que** la valeur caractéristique de l'intervalle est une valeur moyenne de l'amplitude du signal dans l'intervalle.

3. Méthode selon la revendication 1, **caractérisée en ce que** la valeur caractéristique de l'intervalle est l'énergie du signal dans l'intervalle.

4. Méthode selon l'une des revendications 1 à 3, dans laquelle le spectre de référence (RS2) est représentatif d'un signal électromagnétique capté par l'antenne (4) lorsque l'appareil électrique (6) est hors service ou à la première mise en service de l'appareil électrique.

5. Méthode selon l'une des revendications 1 à 3, dans laquelle le spectre de référence (RS2) est représentatif d'un signal électromagnétique capté par une seconde antenne UHF placée dans une enceinte métallique à proximité de l'appareil électrique.

6. Méthode selon la revendication 1, dans laquelle pour identifier les fréquences d'intérêt, on prend en compte des fréquences connues (fc) de bruits électromagnétiques connus lors de la comparaison du spectre du signal reçu sur l'antenne avec le spectre de référence.

7. Méthode selon la revendication 6, dans laquelle pour identifier la ou les fréquences d'intérêt, on prend en compte la probabilité de distribution de l'amplitude du spectre (RS1) du signal reçu, à une fréquence donnée.

8. Méthode pour surveiller l'état d'isolation d'un appareil électrique (6) isolé dans une cuve (5), consistant à détecter au cours du temps des décharges partielles selon l'une des revendications 1 à 7, à suivre dans le temps l'évolution des détections de décharges partielles et quand cette évolution dépasse un seuil prédéterminé, déclencher une alarme.

9. Méthode selon la revendication 8, dans laquelle l'évolution dans le temps des détections de décharges partielles est normalisée sous la forme d'une donnée représentative de l'état d'isolation de l'appareil électrique.

10. Méthode selon la revendication 8 ou 9, dans laquelle l'alarme est une alarme sonore ou visuelle placée à proximité ou à distance de l'appareil électrique surveillé.

11. Système pour diagnostiquer l'état d'isolation d'un ou plusieurs appareils électriques (6) isolés chacun dans une cuve (5), comprenant une unité de traitement de données et de commande (8) agencée pour mettre en oeuvre la méthode selon l'une des revendications 8 à 10, et comprenant une pluralité d'antennes UHF (4,4,4") fournissant une pluralité de signaux électromagnétiques (SD4, SD4', SD4"), lesdites antennes étant reliées à l'unité de traitement et de commande (8) par l'intermédiaire d'un convertisseur parallèle série (9) incluant un multiplexeur électromagnétique haute fréquence (22) qui transforme les flux parallèles de signaux électromagnétiques (SD4,SD4',SD4") en un flux unique d'un signal électromagnétique (SD).

12. Système selon la revendication 11, dans lequel l'unité de traitement et de commande (8) envoie un signal d'horloge (H) définissant des fenêtres temporelles de multiplexage à des moyens (20,21) de transformation qui transforment le signal d'horloge (H) en une série de signaux de puissance (C, C' , C") définissant ensembles lesdites fenêtres temporelles et servant à la commande des relais du multiplexeur électromagnétique (22).

Fig-1

Fig-2

Fig-3

Fig-4

Fig-5

Fig-6

EP 1 484 616 A1

Fig-8

Fig-7

## Fig. 9

## Fig. 10

i = 1 - n

90 — RS2$_i$

91 — PRS2
MRS2

j = 1 - n

92 — RS1$_j$

93 — PRS1
MRS1

fi =200 à0 1500 MHz

# Fig. 11

fi = fc — non

94

Po — oui

non

95 — S1= MRS1(fi) - MRS2(fi)
S2= PRS1(fi) - PRS2(fi)

96

S1>$\alpha_1$
S2>$\alpha_2$ — non

97

oui

98 — fi

**Office européen des brevets**

**RAPPORT DE RECHERCHE EUROPEENNE**

Numéro de la demande

EP 04 10 2489

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,A | US 2002/163344 A1 (ROKUNOHE TOSHIAKI ET AL) 7 novembre 2002 (2002-11-07) * alinéa [0009]; revendications 1,4 * | 1,11 | G01R31/12 |
| A | EP 1 024 573 A (HITACHI LTD) 2 août 2000 (2000-08-02) * abrégé; revendication 3 * | 1,11 | |
| X | EP 0 342 597 A (HITACHI LTD) 23 novembre 1989 (1989-11-23) * abrégé * * page 9, ligne 35 - page 10, ligne 14; figures 13,14 * | 11 | |

**DOMAINES TECHNIQUES RECHERCHES (Int.Cl.7)**

G01R

Le présent rapport a été établi pour toutes les revendications

| Lieu de la recherche | Date d'achèvement de la recherche | Examinateur |
|---|---|---|
| Berlin | 9 septembre 2004 | Binger, B |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.............................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 04 10 2489

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

09-09-2004

| Document brevet cité au rapport de recherche | | Date de publication | Membre(s) de la famille de brevet(s) | | Date de publication |
|---|---|---|---|---|---|
| US 2002163344 | A1 | 07-11-2002 | JP | 10170596 A | 26-06-1998 |
| | | | US | 6424162 B1 | 23-07-2002 |
| | | | CN | 1184940 A | 17-06-1998 |
| | | | US | 5982181 A | 09-11-1999 |
| EP 1024573 | A | 02-08-2000 | JP | 2000224723 A | 11-08-2000 |
| | | | CN | 1262540 A | 09-08-2000 |
| | | | EP | 1024573 A2 | 02-08-2000 |
| | | | US | 6300768 B1 | 09-10-2001 |
| | | | US | 2001040459 A1 | 15-11-2001 |
| EP 0342597 | A | 23-11-1989 | JP | 1287475 A | 20-11-1989 |
| | | | JP | 2008720 C | 11-01-1996 |
| | | | JP | 7038011 B | 26-04-1995 |
| | | | AU | 611800 B2 | 20-06-1991 |
| | | | AU | 3485789 A | 01-02-1990 |
| | | | CN | 1039659 A ,B | 14-02-1990 |
| | | | DE | 68920198 D1 | 09-02-1995 |
| | | | DE | 68920198 T2 | 11-05-1995 |
| | | | EP | 0342597 A2 | 23-11-1989 |
| | | | IN | 173042 A1 | 29-01-1994 |
| | | | KR | 148342 B1 | 01-12-1998 |
| | | | US | 5107447 A | 21-04-1992 |
| | | | US | 5214595 A | 25-05-1993 |

EPO FORM P0460

Pour tout renseignement concernant cette annexe : voir Journal Officiel de l'Office européen des brevets, No.12/82